# FASCICULE DE BREVET EUROPEEN

(11) **EP 3 506 341 B1**
(45) Date de publication et mention de la délivrance du brevet: **29.07.2020**
(21) Numéro de dépôt: 18213125.0
(22) Date de dépôt: 17.12.2018
(51) Int. Cl.: H01L 21/762

(54) **PROCEDE DE TRANSFERT D'UNE COUCHE UTILE SUR UN SUBSTRAT SUPPORT**
ÜBERTRAGUNGSVERFAHREN EINER NUTZSCHICHT AUF EIN TRÄGERSUBSTRAT
METHOD FOR TRANSFERRING A USEFUL FILM ONTO A SUPPORTING SUBSTRATE

(30) Priorité: 28.12.2017 FR 1763342
(43) Date de publication de la demande: 03.07.2019
(73) Titulaire: Commissariat à l'Energie Atomique et aux Energies Alternatives, 75015 Paris (FR)
(72) Inventeur: BENAISSA, Lamine, 38000 GRENOBLE (FR); SALVETAT, Thierry, 38500 VOIRON (FR)
(74) Mandataire: GIE Innovation Competence Group

(56) Documents cités:
- EP-A1- 2 224 476
- US-A1- 2006 118 817
- CHANG-HAN YUN ET AL: "Fabrication of silicon and oxide membranes over cavities using ion-cut layer transfer", JOURNAL OF MICROELECTROMECHANICAL SYSTEMS, IEEE SERVICE CENTER, US, vol. 9, no. 4, 1 December 2000 (2000-12-01), pages 474-477, XP011450865, ISSN: 1057-7157, DOI: 10.1109/84.896768

## Description

### Domaine technique

L'invention se rapporte au domaine technique du transfert d'une couche utile, appartenant à un substrat donneur, sur un substrat support. Le substrat donneur et/ou le substrat support est muni d'au moins une cavité superficielle.

L'invention trouve notamment son application dans la fabrication d'une membrane sur la cavité, utilisée pour les microsystèmes mécaniques (MEMS), par exemple dans un capteur de pression, un résonateur, un microphone, ou encore un capteur biochimique. La couche utile transférée peut également être utilisée comme capot de protection, par exemple pour un composant, ou encore comme moyen d'encapsulation hermétique.

### Etat de la technique antérieure

Un procédé connu de l'état de la technique, notamment du document C.-H. Yun et al., « Fabrication of Silicon and Oxide Membranes Over Cavities Using Ion-Cut Layer Transfer », Journal of Microelectromechanical Systems, vol. 9, n°4, 474-477, 2000 (ci-après D1), est un procédé de transfert d'une couche utile sur un substrat support, le substrat support comportant :
- une première surface et une seconde surface opposée,
- au moins une cavité ménagée à la première surface ;
le procédé comportant les étapes successives :
a') prévoir un substrat donneur comportant :
   - une première surface et une seconde surface opposée,
   - une zone de fragilisation comprenant des espèces implantées,
   - la couche utile, délimitée par la zone de fragilisation et par la première surface du substrat donneur,
b') assembler le substrat donneur au substrat support par un collage entre la première surface du substrat donneur et la première surface du substrat support ;
c') fracturer le substrat donneur suivant la zone de fragilisation de manière à exposer la couche utile.

Un tel procédé de l'état de la technique permet d'obtenir un contrôle satisfaisant de l'épaisseur de la couche utile transférée ainsi qu'une bonne uniformité de l'épaisseur sur le substrat support. Cependant, un tel procédé de l'état de la technique n'est pas entièrement satisfaisant dans la mesure où D1 enseigne que l'épaisseur de la couche utile, notée t, définit une largeur maximale théorique de la cavité, notée Wₗᵢₘ, qui est proportionnelle à t². En d'autres termes, pour une épaisseur t fixée de la couche utile, une largeur de la cavité supérieure à Wₗᵢₘ va conduire à une défaillance de la couche utile transférée sur le substrat support, qui est liée à la formation de bullage (« *blistering »* en langue anglaise) des espèces implantées dans la cavité.

D'autres documents de l'état de la technique pertinentes pour le procédé de transfert sont US2006 / 0118817 A1 et EP2224476 A1.

L'homme du métier recherche, pour une épaisseur fixée de la couche utile, à repousser les limites de la largeur maximale de la cavité au-delà de laquelle on observe une défaillance de la couche utile transférée sur le substrat support.

### Exposé de l'invention

L'invention vise à remédier en tout ou partie aux inconvénients précités. A cet effet, l'invention a pour objet un procédé de transfert d'une couche utile sur un substrat support comportant une première surface, le procédé comportant les étapes successives :
a) prévoir un substrat donneur comportant :
   - une première surface,
   - une zone de fragilisation comprenant des espèces implantées,
   - la couche utile, délimitée par la zone de fragilisation et par la première surface du substrat donneur,
   - une zone amorphe s'étendant dans la couche utile, parallèlement à la zone de fragilisation ;
b) assembler, du côté de la première surface du substrat donneur et du côté de la première surface du substrat support, le substrat donneur au substrat support par un collage ; l'étape b) étant exécutée de sorte que la zone amorphe est au moins partiellement en regard d'au moins une cavité délimitée en partie par la première surface du substrat donneur ;
c) fracturer le substrat donneur suivant la zone de fragilisation de manière à exposer la couche utile.

Ainsi, un tel procédé selon l'invention permet, grâce à la présence d'une telle zone amorphe, de repousser les limites de la largeur maximale de la cavité au-delà de laquelle on observe une défaillance de la couche utile transférée sur le substrat support. En effet, une telle zone amorphe permet d'inhiber localement le bullage des espèces implantées, provoqué par le gaz issu de la recombinaison desdites espèces. De plus, cette inhibition du bullage des espèces implantées permet de transférer une couche utile fine, sans craindre sa défaillance mécanique, voire sa rupture. L'inhibition du bullage des espèces implantées est accrue lorsque la zone amorphe se trouve totalement en regard de la cavité à l'issue de l'étape b).

En outre, une telle zone amorphe présente un module d'Young plus faible qu'une structure monocristalline (par exemple de l'ordre de 20% plus faible pour le silicium amorphe par rapport au silicium monocristallin), ce qui permet de réduire les risques de propagation d'une fissure lors de l'étape c).

Par ailleurs, le fait que la zone amorphe s'étende parallèlement à la zone de fragilisation autorise une fracture du substrat donneur lors de l'étape c) qui s'opère parallèlement à la cavité.

### Définitions

- Par « couche utile », on entend une couche à partir de laquelle peut être formé un dispositif pour tout type d'applications, notamment électronique, mécanique, optique ; ou encore une couche formant un capot de protection.
- Par «substrat », on entend un support physique autoporté, réalisé dans un matériau de base permettant la fabrication d'un dispositif électronique ou d'un composant électronique. Un substrat est classiquement une tranche (« *wafer »* en langue anglaise) découpée dans un lingot monocristallin de matériau semi-conducteur.
- Par « amorphe », on entend que la zone présente un taux de cristallinité massique strictement inférieur à celui du substrat donneur, le substrat donneur possédant une structure monocristalline. Ainsi, la zone « amorphe » peut avoir une structure polycristalline (taux de cristallinité massique classiquement inférieur ou égal à 80%) ou une structure amorphe (taux de cristallinité massique classiquement inférieur ou égal à 20%).
- Le terme « parallèlement » s'entend dans les tolérances usuelles liées aux techniques de fabrication en microélectronique, et non au sens mathématique du terme.
- Par « au moins partiellement en regard », on entend que tout ou partie de la zone amorphe se situe en face (i.e. à la perpendiculaire) de tout ou partie de la cavité, avec ou sans interposition d'une portion de couche utile. Ainsi, l'expression couvre les cas suivants :
   (i) toute la zone amorphe se situe en face de toute la cavité,
   (ii) toute la zone amorphe se situe en face d'une partie de la cavité,
   (iii) une partie de la zone amorphe se situe en face de toute la cavité,
   (iv) une partie de la zone amorphe se situe en face d'une partie de la cavité.

Le procédé selon l'invention peut comporter une ou plusieurs des caractéristiques suivantes.

Selon une caractéristique de l'invention, la cavité est ménagée à la première surface du substrat support ;
et le collage de l'étape b) s'opère entre la première surface du substrat donneur et la première surface du substrat support.

Selon une caractéristique de l'invention, le substrat support comporte des piliers, s'étendant à la première surface du substrat support, et délimitant en partie la cavité ;
et le collage de l'étape b) s'opère entre la première surface du substrat donneur et les piliers du substrat support.

Selon une caractéristique de l'invention, le substrat donneur prévu lors de l'étape a) comporte des piliers, s'étendant à la première surface du substrat donneur, et délimitant en partie la cavité ;
et le collage de l'étape b) s'opère entre les piliers du substrat donneur et la première surface du substrat support.

Selon une caractéristique de l'invention, le substrat support comporte des piliers, s'étendant à la première surface du substrat support, et délimitant en partie une première cavité ;
le substrat donneur prévu lors de l'étape a) comporte des piliers, s'étendant à la première surface du substrat donneur, et délimitant en partie une deuxième cavité ;
et le collage de l'étape b) s'opère entre les piliers du substrat donneur et les piliers du substrat support de manière à réunir les première et deuxième cavités et former la cavité.

Selon une caractéristique de l'invention, le procédé comporte une étape d) consistant à recristalliser la zone amorphe, l'étape d) étant exécutée après l'étape c) ; l'étape d) étant de préférence exécutée par une reprise d'épitaxie en phase solide.

Ainsi, la zone amorphe est recristallisée lors de l'étape d) afin de reconstruire la structure cristalline de la couche utile, et ce à partir du matériau cristallin entourant la zone amorphe. L'étape d) est essentielle lorsque l'on souhaite former un dispositif électronique à partir de la couche utile.

Selon une caractéristique de l'invention, l'étape a) comporte les étapes :
a₀) prévoir le substrat donneur comportant la première surface ;
a₁) former la zone de fragilisation dans le substrat donneur ;
a₂) former la zone amorphe dans la couche utile.
Les étapes a₁) et a₂) peuvent être interverties.

Selon une caractéristique de l'invention, l'étape a₁) consiste à implanter des espèces ionisées dans le substrat donneur, à travers la première surface du substrat donneur, lesdites espèces ionisées comportant de préférence au moins une des espèces sélectionnées parmi H⁺, He⁺, B⁺.

Selon une caractéristique de l'invention, l'étape a₂) consiste à implanter des espèces dans la couche utile, à travers la première surface du substrat donneur, lesdites espèces étant de préférence des ions de silicium ou des ions de germanium.

Ainsi, un avantage procuré est de pouvoir obtenir aisément une zone amorphe « enterrée », c'est-à-dire située à distance de la première surface du substrat donneur, ce qui n'est pas envisageable avec une technique de dépôt.

Selon une caractéristique de l'invention, l'étape a₂) est exécutée de sorte que la zone amorphe s'étend à distance de la première surface du substrat donneur.

Ainsi, un avantage procuré par une telle zone amorphe enterrée, plus proche de la zone de fragilisation, est d'améliorer l'efficacité de l'inhibition du bullage des espèces implantées, provoqué par le gaz issu de la recombinaison desdites espèces. En outre, le cas échéant, une telle zone amorphe enterrée permet d'améliorer la qualité de la recristallisation lors de l'étape d). Enfin, un autre avantage procuré par une telle zone amorphe enterrée est qu'elle peut être supprimée simplement, par oxydation sacrificielle ou amincissement.

Selon une caractéristique de l'invention, la couche utile du substrat donneur prévu lors de l'étape a) présente une densité volumique, notée pi ;
et l'étape a₂) est exécutée de sorte que la zone amorphe présente une densité volumique, notée ρ₂, vérifiant ρ₂ ≥ ρ₁/10.

Ainsi, un avantage procuré est d'améliorer l'efficacité de l'inhibition du bullage des espèces implantées.

Selon une caractéristique de l'invention, la couche utile du substrat donneur prévu lors de l'étape a) présente une épaisseur, notée t, définissant une largeur maximale théorique de la cavité, notée Wₗᵢₘ, qui est proportionnelle à t² ;
et l'étape a₂) est exécutée de sorte que la zone amorphe forme un réseau périodique avec un pas, noté p, vérifiant p < Wₗᵢₘ, le réseau périodique s'étendant parallèlement à la première surface du substrat donneur.

Ainsi, un avantage procuré par un tel réseau périodique est de pouvoir obtenir une excellente inhibition du bullage des espèces implantées, et ce sans nécessiter d'avoir une zone amorphe s'étendant totalement en regard de la cavité à l'issue de l'étape b) -impliquant un alignement qui peut être délicat à opérer-.

Selon une caractéristique de l'invention, l'étape c) est exécutée en appliquant un recuit thermique à l'assemblage obtenu à l'issue de l'étape b).

Par « recuit thermique », on entend un traitement thermique comportant un cycle de chauffage avec :
- une première phase de montée graduelle en température jusqu'à atteindre une valeur plateau,
- une deuxième phase où la température de chauffage conserve la valeur plateau, et
- une troisième phase de refroidissement.

La température du recuit thermique est la valeur plateau de la température de chauffage.

Selon une caractéristique de l'invention, le substrat donneur prévu lors de l'étape a) est réalisé dans un matériau sélectionné parmi :
- un matériau semi-conducteur, de préférence Si, Ge, GaAs, InP, GaN ;
- un matériau piézoélectrique, de préférence LiNbO₃, LiTaO₃.

Par « semi-conducteur », on entend que le matériau présente une conductivité électrique à 300 K comprise entre 10⁻⁸ S/cm et 10³ S/cm.

### Brève description des dessins

D'autres caractéristiques et avantages apparaîtront dans l'exposé détaillé de différents modes de réalisation de l'invention, l'exposé étant assorti d'exemples et de références aux dessins joints.
Figures la à 1g sont des vues schématiques en coupe selon la normale aux premières surfaces -et secondes surfaces- des substrats donneur et support, illustrant des étapes d'un procédé selon l'invention.
Figures 2a à 2f sont des vues schématiques en coupe selon la normale aux premières surfaces -et secondes surfaces- des substrats donneur et support, illustrant des étapes d'un procédé selon l'invention.
Figures 3a à 3f sont des vues schématiques en coupe selon la normale aux premières surfaces -et secondes surfaces- des substrats donneur et support, illustrant des étapes d'un procédé selon l'invention.
Figures 4a à 4g sont des vues schématiques en coupe selon la normale aux premières surfaces -et secondes surfaces- des substrats donneur et support, illustrant des étapes d'un procédé selon l'invention.

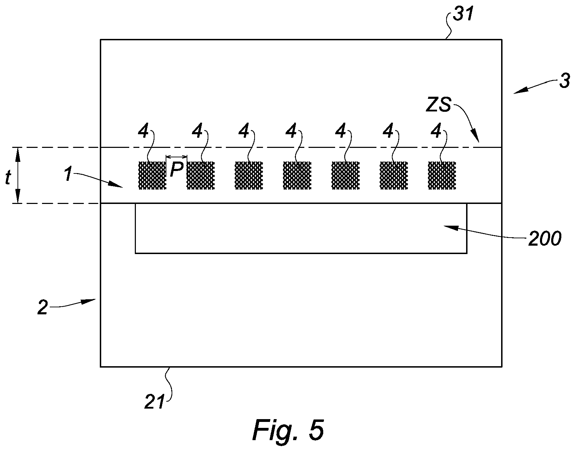

Figure 5 est une vue schématique en coupe selon la normale aux premières surfaces -et secondes surfaces- des substrats donneur et support, illustrant une zone amorphe formant un réseau périodique.

Les figures ne sont pas représentées à l'échelle pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de transfert d'une couche utile 1 sur un substrat support 2 comportant une première surface 20, le procédé comportant les étapes successives :
a) prévoir un substrat donneur 3 comportant :
   - une première surface 30,
   - une zone de fragilisation ZS comprenant des espèces implantées,
   - la couche utile 1, délimitée par la zone de fragilisation ZS et par la première surface 30 du substrat donneur 3,
   - une zone amorphe 4 s'étendant dans la couche utile 1, parallèlement à la zone de fragilisation ZS ;
b) assembler, du côté de la première surface 30 du substrat donneur 3 et du côté de la première surface 20 du substrat support 2, le substrat donneur 3 au substrat support 2 par un collage ; l'étape b) étant exécutée de sorte que la zone amorphe 4 est au moins partiellement en regard d'au moins une cavité 200 délimitée en partie par la première surface 30 du substrat donneur 3 ;
c) fracturer le substrat donneur 3 suivant la zone de fragilisation ZS de manière à exposer la couche utile 1.

### Substrat support

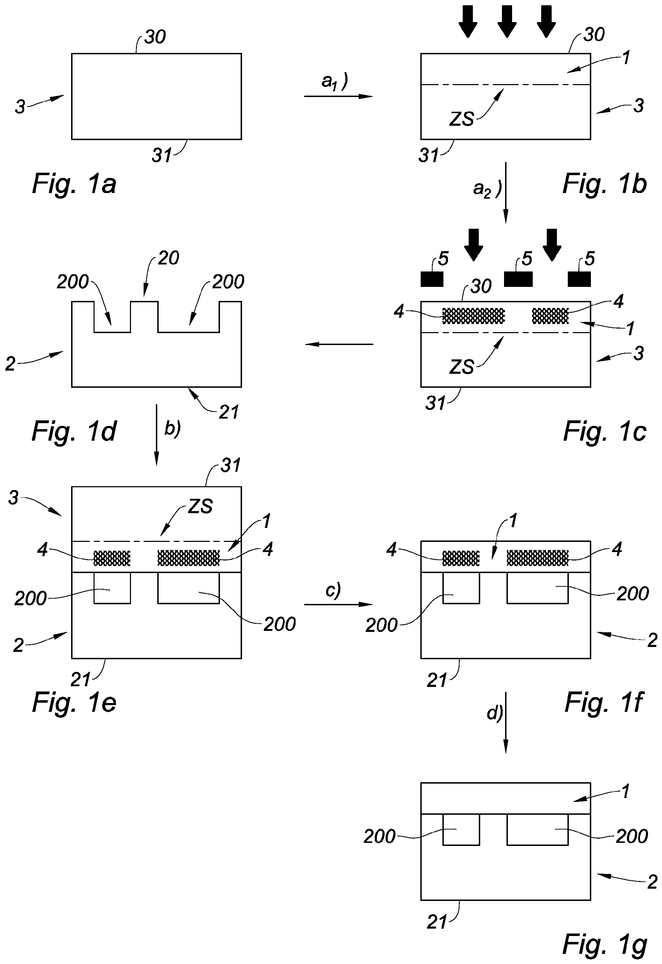

Comme illustré à la figure 1d, selon un mode de réalisation, la ou les cavités 200 sont formées à la première surface 20 du substrat support 2, de préférence par des étapes de photolithographie et de gravure. Le substrat support 2 comporte une seconde surface 21, opposée à la première surface 20.

La première surface 20 du substrat support 2 peut être recouverte d'une couche d'oxyde. La couche d'oxyde peut être un oxyde thermique. A titre de variante, la première surface 20 du substrat support 2 peut être recouverte d'une couche métallique. La couche métallique est réalisée dans un matériau métallique, de préférence sélectionné parmi Au, Cu, Ti, W.

### Substrat donneur

Le substrat donneur 3 prévu lors de l'étape a) comporte une seconde surface 31, opposée à la première surface 30. Le substrat donneur 3 prévu lors de l'étape a) est avantageusement réalisé dans un matériau sélectionné parmi :
- un matériau semi-conducteur, de préférence Si, Ge, GaAs, InP, GaN ;
- un matériau piézoélectrique, de préférence LiNbO₃, LiTaO₃.

Lorsque la première surface 20 du substrat support 2 est recouverte d'une couche d'oxyde, la première surface 30 du substrat donneur 3 est avantageusement recouverte d'une couche d'oxyde afin de favoriser un collage hydrophile lors de l'étape b). Lorsque la première surface 20 du substrat support 2 est recouverte d'une couche métallique, la première surface 30 du substrat donneur 3 est avantageusement recouverte d'une couche métallique, de préférence du même métal, afin de favoriser un collage par thermocompression lors de l'étape b).

Le substrat donneur 3 présente une structure monocristalline.

L'étape a) comporte avantageusement les étapes :
a₀) prévoir le substrat donneur 3 comportant la première surface 30 et la seconde surface 31 opposée ;
a₁) former la zone de fragilisation ZS dans le substrat donneur 3 ;
a₂) former la zone amorphe 4 dans la couche utile 1.

Les étapes a₁) et a₂) peuvent être interverties. L'étape a₀) est illustrée à la figure la. L'étape a₁) est illustrée à la figure 1b. L'étape a₂) est illustrée à la figure le.

L'étape a₁) consiste avantageusement à implanter des espèces ionisées dans le substrat donneur 3, à travers la première surface 30 du substrat donneur 3, lesdites espèces ionisées comportant de préférence au moins une des espèces sélectionnées parmi H⁺, He⁺, B⁺. Il est donc possible d'effectuer une co-implantation avec plusieurs espèces ionisées (e.g. H⁺ et B⁺), ou encore d'effectuer une multi-implantation des mêmes espèces ionisées. A titre d'exemple non limitatif, lorsque le substrat donneur 3 est réalisé en silicium monocristallin et lorsque les espèces implantées sont des ions H⁺, l'étape a₁) peut être exécutée selon les paramètres suivants :
- une énergie comprise entre 60 keV et 200 keV,
- une dose comprise 5x10¹⁶ at.cm⁻² et 10¹⁷ at.cm⁻².

Les paramètres seront adaptés selon l'épaisseur souhaitée pour la couche utile 1. Par exemple, lorsque le substrat donneur 3 est réalisé en silicium monocristallin, une énergie de 160 keV et une dose de 6x10¹⁶ at.cm⁻² conduisent à une épaisseur de 1,5 µm pour la couche utile 1.

L'étape a₂) consiste avantageusement à implanter des espèces dans la couche utile 1, à travers la première surface 30 du substrat donneur 3, lesdites espèces étant de préférence des ions de silicium ou des ions de germanium. L'implantation des espèces est exécutée lors de l'étape a₂) à travers un masque 5 (illustré à la figure 1c). Le masque 5 peut être un masque dur ou une résine photosensible épaisse (de l'ordre de 3 µm). L'étape a₂) est avantageusement exécutée de sorte que la zone amorphe 4 s'étend à distance de la première surface 30 du substrat donneur 3. A titre d'exemple non limitatif, lorsque le substrat donneur 3 est réalisé en silicium monocristallin et lorsque les espèces implantées sont des ions de silicium, l'étape a₂) peut être exécutée selon les paramètres suivants :
- une énergie comprise entre 10 keV et 150 keV,
- une dose comprise 10¹⁴ at.cm⁻² et 5x10¹⁵ at.cm⁻².

Les paramètres seront adaptés selon la profondeur d'amorphisation souhaitée.

Selon une variante, l'étape a₂) comporte les étapes :
a₂₀) graver une partie de la première surface 30 du substrat donneur 3 ;
a₂₁) déposer une couche amorphe dans ladite partie gravée de manière à former la zone amorphe 4.

La couche utile 1 du substrat donneur 3 prévu lors de l'étape a) présente une densité volumique, notée pi. L'étape a₂) est avantageusement exécutée de sorte que la zone amorphe 4 présente une densité volumique, notée ρ₂, vérifiant ρ₂ ≥ ρ₁/10.

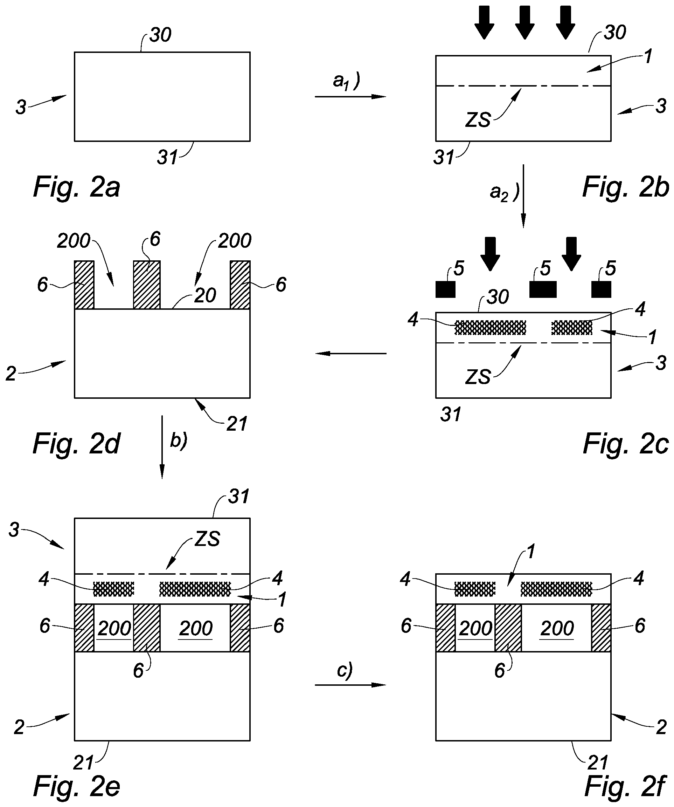

La couche utile 1 du substrat donneur 3 prévu lors de l'étape a) présente une épaisseur, notée t, définissant une largeur maximale théorique de la cavité, notée Wₗᵢₘ, qui est proportionnelle à t², comme décrit dans D1. Selon un mode de mise en œuvre illustré à la figure 2, l'étape a₂) est exécutée de sorte que la zone amorphe 4 forme un réseau périodique avec un pas, noté p, vérifiant p < Wₗᵢₘ, le réseau périodique s'étendant parallèlement à la première surface 30 du substrat donneur 3. A titre d'exemple non limitatif, lorsque le substrat donneur 3 est réalisé en silicium monocristallin, et lorsque l'épaisseur t de la couche utile 1 est de l'ordre de 1,5 µm, alors Wₗᵢₘ est de l'ordre de 40 µm.

### Etape b) de collage

L'étape b) est illustrée à la figure 1e. Les étapes a₂) et b) sont configurées de sorte que les cas suivants peuvent se présenter à l'issue de l'étape b) :
(i) toute la zone amorphe 4 se situe en face de toute la cavité 200,
(ii) toute la zone amorphe 4 se situe en face d'une partie de la cavité 200,
(iii) une partie de la zone amorphe 4 se situe en face de toute la cavité 200,
(iv) une partie de la zone amorphe 4 se situe en face d'une partie de la cavité 200.

On privilégiera le cas (i) afin d'optimiser l'inhibition du bullage des espèces implantées.

Lorsque la ou les cavités 200 sont ménagées à la première surface 20 du substrat support 2, le collage de l'étape b) s'opère entre la première surface 30 du substrat donneur 3 et la première surface 20 du substrat support 2. Lorsque le substrat support 2 est muni d'une seule cavité 200, l'étape b) est exécutée de sorte que la zone amorphe 4 est au moins partiellement en regard de la cavité 200. Lorsque le substrat support 2 est muni de plusieurs cavités 200, l'étape b) est exécutée de sorte que la zone amorphe 4 est au moins partiellement en regard de chaque cavité 200.

Le côté de la première surface 30 du substrat donneur 3 est défini par l'orientation de la normale à la première surface 30 du substrat donneur 3. De la même façon, le côté de la première surface 20 du substrat support 2 est défini par l'orientation de la normale à la première surface 20 du substrat support 2.

Comme illustré à la figure 1e, à l'issue de l'étape b), chaque cavité 200 est délimitée :
- en partie par la première surface 30 du substrat donneur 3,
- en partie par la première surface 20 du substrat support 2.

Le collage exécuté lors de l'étape b) est avantageusement un collage par adhésion directe entre la première surface 30 du substrat donneur 3 et la première surface 20 du substrat support 2. Par « adhésion directe », on entend un collage spontané issu de la mise en contact de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre deux surfaces. On parle également de collage par adhésion moléculaire ou de collage direct. Le collage par adhésion directe ne saurait être assimilé à un collage par thermocompression, à un collage eutectique, ou encore à un collage anodique.

Toutefois, le collage exécuté lors de l'étape b) peut être un collage par thermocompression ou un collage eutectique selon la nature de la première surface 30 du substrat donneur 3 et de la première surface 20 du substrat support 2.

L'étape b) est avantageusement précédée d'une préparation de la première surface 30 du substrat donneur 3 et d'une préparation de la première surface 20 du substrat support 2. A titre d'exemple, pour un collage direct, il est possible d'activer chimiquement les premières surfaces 20, 30, par exemple à l'aide d'un acide de Caro (produit par un mélange de H₂SO₄ et de H₂O₂), puis de nettoyer les premières surfaces 20, 30 par un procédé standard de type RCA. A titre de variante, pour un collage direct, il est possible d'activer les premières surfaces 20, 30 par un polissage mécano-chimique (CMP), puis de nettoyer les premières surfaces 20, 30 avec une brosse de nettoyage (« *scrubber »* en langue anglaise).

L'étape b) est avantageusement exécutée dans un milieu à atmosphère contrôlée. A titre d'exemple non limitatif, l'étape b) peut être exécutée sous vide poussé tel qu'un vide secondaire inférieur à 10⁻² mbar.

### Etape c) de fracture

L'étape c) est illustrée à la figure 1f. L'étape c) de fracture (« *splitting »* en langue anglaise) est avantageusement exécutée en appliquant un recuit thermique à l'assemblage obtenu à l'issue de l'étape b).

Le recuit thermique est appliqué selon un budget thermique adapté pour fracturer le substrat donneur 3 suivant la zone de fragilisation ZS. La température de recuit thermique est de préférence comprise entre 350°C et 550°C. La durée du recuit thermique est de préférence comprise entre 5 minutes et 3 heures.

L'étape c) est avantageusement précédée d'une étape consistant à appliquer un recuit thermique à l'assemblage obtenu lors de l'étape b) selon un budget thermique adapté pour renforcer le collage sans initier la fracture du substrat donneur 3 suivant la zone de fragilisation ZS.

### Etape d) de recristallisation

Le procédé comporte avantageusement une étape d) consistant à recristalliser la zone amorphe 4, l'étape d) étant exécutée après l'étape c). L'étape d) est illustrée à la figure 1g. L'étape d) est avantageusement exécutée par une reprise d'épitaxie en phase solide. Ainsi, un avantage procuré est de pouvoir reconstruire aisément une structure cristalline pour la couche utile 1. L'étape d) est essentielle lorsque l'on souhaite former un dispositif électronique à partir de la couche utile 1. Pour cette application, l'étape a₂) est avantageusement exécutée de sorte que la zone amorphe 4 présente un taux de cristallinité massique inférieur ou égal à 20%, ce qui permet d'améliorer la qualité de la recristallisation. L'étape d) est exécutée en appliquant un recuit thermique. A titre d'exemple non limitatif, lorsque la zone amorphe 4 est du silicium amorphe, la recristallisation débute à 450°C.

A titre de variante, l'étape d) peut être exécutée :
- par un recuit thermique rapide par énergie micro-onde, ou
- par un laser de recristallisation.

### Finition

Le procédé selon l'invention comporte avantageusement :
- une étape d'oxydation sacrificielle de la couche utile 1, exécutée après l'étape d), de manière à ajuster l'épaisseur finale de la couche utile 1 et ôter les parties endommagées par l'implantation des espèces ionisées ;
- une étape de polissage mécano-chimique pour améliorer l'état de surface de la couche utile 1.

Le procédé peut également comporter des étapes de gravure sèche ou humide, ainsi que des étapes de nettoyage de la couche utile 1.

### Application à la formation d'un capot de protection

Selon le mode de réalisation illustré aux figures 2a à 2f, le substrat support 2 comporte des piliers 6, s'étendant à la première surface 20 du substrat support 2, et délimitant en partie la cavité 200. Le collage de l'étape b) s'opère entre la première surface 30 du substrat donneur 3 et les piliers 6 du substrat support 2. Les piliers 6 du substrat support 2 peuvent délimiter en partie plusieurs cavités 200. Comme illustré à la figure 2e, à l'issue de l'étape b), chaque cavité 200 est délimitée :
- en partie par la première surface 30 du substrat donneur 3,
- en partie par la première surface 20 du substrat support 2,
- en partie par les piliers 6 du substrat support 2.

Les caractéristiques techniques décrites ci-avant pour les étapes a), b) et c) s'appliquent pour cet objet, excepté le collage direct de l'étape b) qui n'est pas envisageable dans ce cas. L'étape d) est facultative. En effet, lorsque la couche utile 1 forme un capot de protection, un dispositif électronique n'est pas nécessairement formé à partir de la couche utile 1. Pour cette application, l'étape a₂) peut être exécutée de sorte que la zone amorphe 4 présente un taux de cristallinité massique inférieur ou égal à 80%. En d'autres termes, une structure polycristalline de la zone amorphe 4 convient parfaitement dès lors qu'un dispositif électronique n'a pas à être formé à partir de la couche utile 1.

Les piliers 6 sont avantageusement réalisés dans un matériau métallique, de préférence en cuivre. A titre d'exemple non limitatif, les piliers 6 sont formés à la première surface 20 du substrat support 2 par électrodéposition (ECD pour « *ElectroChemical Déposition* »). Le collage exécuté lors de l'étape b) est avantageusement un collage par thermocompression.

Ainsi, une telle couche utile 1 transférée forme localement un capot de protection, de préférence hermétique, sur le substrat support 2, de manière à former un moyen d'encapsulation. Une telle couche utile 1 transférée forme un moyen d'encapsulation plus efficace qu'une couche *ad hoc* déposée, percée puis rebouchée.

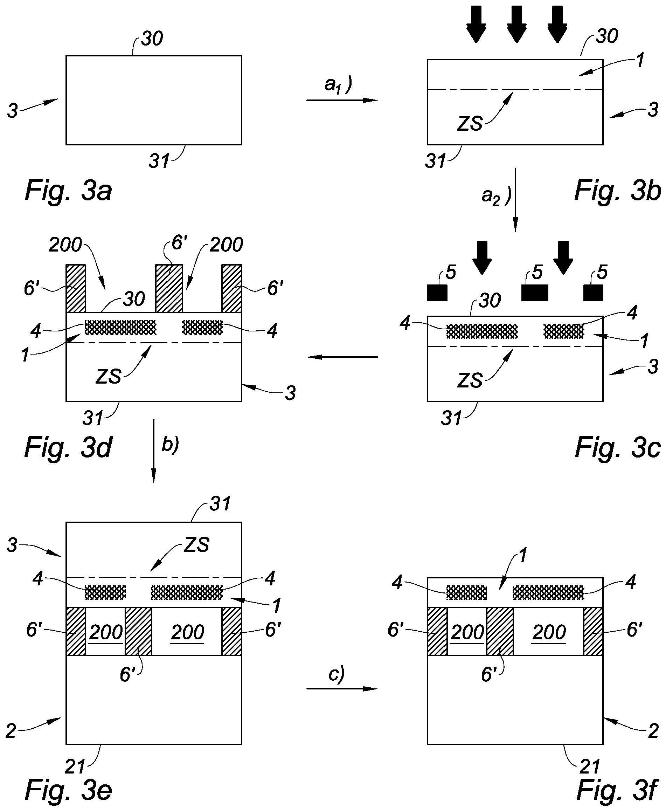

A titre de variante illustrée aux figures 3a à 3f, le substrat donneur 3 prévu lors de l'étape a) comporte des piliers 6', s'étendant à la première surface 30 du substrat donneur 3, et délimitant en partie la cavité 200. Le collage de l'étape b) s'opère entre les piliers 6' du substrat donneur 3 et la première surface 20 du substrat support 2. Les piliers 6' du substrat donneur 3 peuvent délimiter en partie plusieurs cavités 200. Comme illustré à la figure 3e, à l'issue de l'étape b), chaque cavité 200 est délimitée :
- en partie par la première surface 30 du substrat donneur 3,
- en partie par la première surface 20 du substrat support 2,
- en partie par les piliers 6' du substrat donneur 3.

Les caractéristiques techniques décrites ci-avant pour les étapes a), b) et c) s'appliquent pour cet objet, excepté le collage direct de l'étape b) qui n'est pas envisageable dans ce cas. L'étape d) est facultative. En effet, lorsque la couche utile 1 forme un capot de protection, un dispositif électronique n'est pas nécessairement formé à partir de la couche utile 1. Pour cette application, l'étape a₂) peut être exécutée de sorte que la zone amorphe 4 présente un taux de cristallinité massique inférieur ou égal à 80%. En d'autres termes, une structure polycristalline de la zone amorphe 4 convient parfaitement dès lors qu'un dispositif électronique n'a pas à être formé à partir de la couche utile 1.

Les piliers 6' sont avantageusement réalisés dans un matériau métallique, de préférence en cuivre. A titre d'exemple non limitatif, les piliers 6' sont formés à la première surface 30 du substrat donneur 3 par électrodéposition (ECD pour « *ElectroChemical Déposition* »). Le collage exécuté lors de l'étape b) est avantageusement un collage par thermocompression.

Ainsi, une telle couche utile 1 transférée forme localement un capot de protection, de préférence hermétique, sur le substrat support 2, de manière à former un moyen d'encapsulation. Une telle couche utile 1 transférée forme un moyen d'encapsulation plus efficace qu'une couche *ad hoc* déposée, percée puis rebouchée.

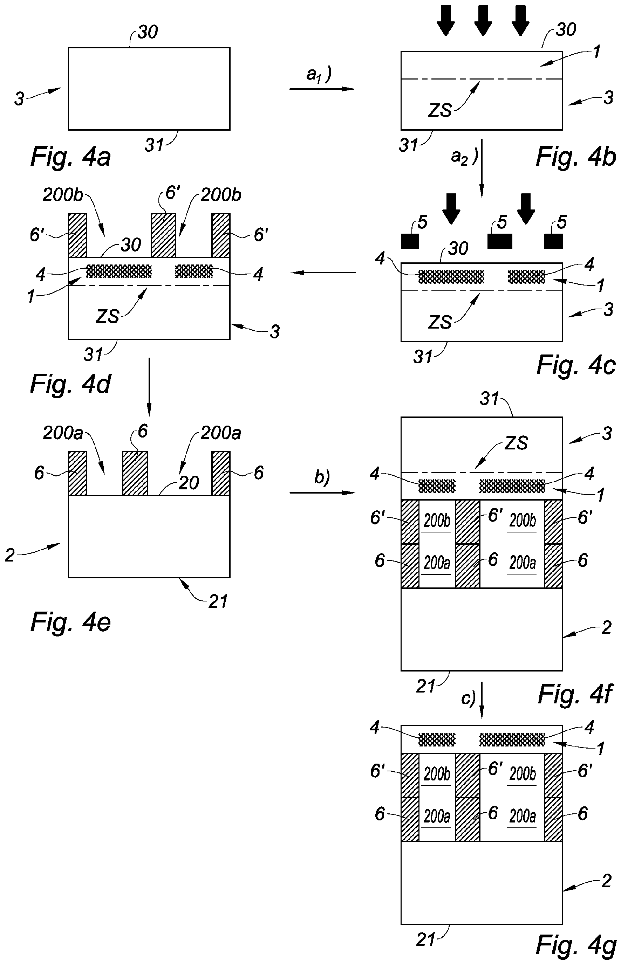

A titre de variante illustrée aux figures 4a à 4g, le substrat support 2 comporte des piliers 6, s'étendant à la première surface 20 du substrat support 2, et délimitant en partie une première cavité 200a. Le substrat donneur 3 prévu lors de l'étape a) comporte des piliers 6', s'étendant à la première surface 30 du substrat donneur 3, et délimitant en partie une deuxième cavité 200b. Le collage de l'étape b) s'opère entre les piliers 6' du substrat donneur 3 et les piliers 6 du substrat support 2 de manière à réunir les première et deuxième cavités 200a, 200b et former la cavité 200. Les piliers 6 du substrat support 2 peuvent délimiter en partie plusieurs premières cavités 200a. Les piliers 6' du substrat donneur 3 peuvent délimiter en partie plusieurs deuxièmes cavités 200b. La réunion des premières et deuxièmes cavités 200a, 200b forme plusieurs cavités 200. Comme illustré à la figure 4f, à l'issue de l'étape b), chaque cavité 200 est délimitée :
- en partie par la première surface 30 du substrat donneur 3,
- en partie par la première surface 20 du substrat support 2,
- en partie par les piliers 6' du substrat donneur 3,
- en partie par les piliers 6 du substrat support 2.

Les caractéristiques techniques décrites ci-avant pour les étapes a), b) et c) s'appliquent pour cet objet, excepté le collage direct de l'étape b) qui n'est pas envisageable dans ce cas. L'étape d) est facultative. En effet, lorsque la couche utile 1 forme un capot de protection, un dispositif électronique n'est pas nécessairement formé à partir de la couche utile 1. Pour cette application, l'étape a₂) peut être exécutée de sorte que la zone amorphe 4 présente un taux de cristallinité massique inférieur ou égal à 80%. En d'autres termes, une structure polycristalline de la zone amorphe 4 convient parfaitement dès lors qu'un dispositif électronique n'a pas à être formé à partir de la couche utile 1.

Les piliers 6 du substrat support 2 et les piliers 6' du substrat donneur 3 sont avantageusement réalisés dans un matériau métallique, de préférence en cuivre. A titre d'exemple non limitatif, les piliers 6 du substrat support 2 et les piliers 6' du substrat donneur 3 sont respectivement formés à la première surface 20 du substrat support 2 et à la première surface 30 du substrat donneur 3 par électrodéposition (ECD pour « *ElectroChemical Déposition* »). Le collage exécuté lors de l'étape b) est avantageusement un collage par thermocompres sion.

Ainsi, une telle couche utile 1 transférée forme localement un capot de protection, de préférence hermétique, sur le substrat support 2, de manière à former un moyen d'encapsulation. Une telle couche utile 1 transférée forme un moyen d'encapsulation plus efficace qu'une couche *ad hoc* déposée, percée puis rebouchée.

L'invention ne se limite pas aux modes de réalisation exposés. L'homme du métier est mis à même de considérer leurs combinaisons techniquement opérantes, et de leur substituer des équivalents.

## Revendications

1. Procédé de transfert d'une couche utile (1) sur un substrat support (2) comportant une première surface (20), le procédé comportant les étapes successives :
a) prévoir un substrat donneur (3) comportant :
- une première surface (30),
- une zone de fragilisation (ZS) comprenant des espèces implantées,
- la couche utile (1), délimitée par la zone de fragilisation (ZS) et par la première surface (30) du substrat donneur (3),
- une zone amorphe (4) s'étendant dans la couche utile (1), parallèlement à la zone de fragilisation (ZS) ;
b) assembler, du côté de la première surface (30) du substrat donneur (3) et du côté de la première surface (20) du substrat support (2), le substrat donneur (3) au substrat support (2) par un collage ; l'étape b) étant exécutée de sorte que la zone amorphe (4) est au moins partiellement en regard d'au moins une cavité (200) délimitée en partie par la première surface (30) du substrat donneur (3) ;
c) fracturer le substrat donneur (3) suivant la zone de fragilisation (ZS) de manière à exposer la couche utile (1).

2. Procédé selon la revendication 1, dans lequel la cavité (200) est ménagée à la première surface (20) du substrat support (2) ;
et dans lequel le collage de l'étape b) s'opère entre la première surface (30) du substrat donneur (3) et la première surface (20) du substrat support (2).

3. Procédé selon la revendication 1, dans lequel le substrat support (2) comporte des piliers (6), s'étendant à la première surface (20) du substrat support (2), et délimitant en partie la cavité (200) ;
et dans lequel le collage de l'étape b) s'opère entre la première surface (30) du substrat donneur (3) et les piliers (6) du substrat support (2).

4. Procédé selon la revendication 1, dans lequel le substrat donneur (3) prévu lors de l'étape a) comporte des piliers (6'), s'étendant à la première surface (30) du substrat donneur (3), et délimitant en partie la cavité (200) ;
et dans lequel le collage de l'étape b) s'opère entre les piliers (6') du substrat donneur (3) et la première surface (20) du substrat support (2).

5. Procédé selon la revendication 1, dans lequel le substrat support (2) comporte des piliers (6), s'étendant à la première surface (20) du substrat support (2), et délimitant en partie une première cavité (200a) ;
dans lequel le substrat donneur (3) prévu lors de l'étape a) comporte des piliers (6'), s'étendant à la première surface (30) du substrat donneur (3), et délimitant en partie une deuxième cavité (200b) ;
et dans lequel le collage de l'étape b) s'opère entre les piliers (6') du substrat donneur (3) et les piliers (6) du substrat support (2) de manière à réunir les première et deuxième cavités (200a, 200b) et former la cavité (200).

6. Procédé selon l'une des revendications 1 à 5, comportant une étape d) consistant à recristalliser la zone amorphe (4), l'étape d) étant exécutée après l'étape c) ; l'étape d) étant de préférence exécutée par une reprise d'épitaxie en phase solide.

7. Procédé selon l'une des revendications 1 à 6, dans lequel l'étape a) comporte les étapes :
a₀) prévoir le substrat donneur (3) comportant la première surface (30) ;
a₁) former la zone de fragilisation (ZS) dans le substrat donneur (3) ;
a₂) former la zone amorphe (4) dans la couche utile (1).

8. Procédé selon la revendication 7, dans lequel l'étape a₁) consiste à implanter des espèces ionisées dans le substrat donneur (3), à travers la première surface (30) du substrat donneur (3), lesdites espèces ionisées comportant de préférence au moins une des espèces sélectionnées parmi H⁺, He⁺, B⁺.

9. Procédé selon la revendication 7 ou 8, dans lequel l'étape a₂) consiste à implanter des espèces dans la couche utile (1), à travers la première surface (30) du substrat donneur (3), lesdites espèces étant de préférence des ions de silicium ou des ions de germanium.

10. Procédé selon l'une des revendications 7 à 9, dans lequel l'étape a₂) est exécutée de sorte que la zone amorphe (4) s'étend à distance de la première surface (30) du substrat donneur (3).

11. Procédé selon l'une des revendications 7 à 10, dans lequel la couche utile (1) du substrat donneur (3) prévu lors de l'étape a) présente une densité volumique, notée pi ;
et dans lequel l'étape a₂) est exécutée de sorte que la zone amorphe (4) présente une densité volumique, notée ρ₂, vérifiant ρ₂ ≥ ρ₁/10.

12. Procédé selon l'une des revendications 7 à 11, dans lequel la couche utile (1) du substrat donneur (3) prévu lors de l'étape a) présente une épaisseur, notée t, définissant une largeur maximale théorique de la cavité, notée Wₗᵢₘ, qui est proportionnelle à t² ;
et dans lequel l'étape a₂) est exécutée de sorte que la zone amorphe (4) forme un réseau périodique avec un pas, noté p, vérifiant p < Wₗᵢₘ, le réseau périodique s'étendant parallèlement à la première surface (30) du substrat donneur (3).

13. Procédé selon l'une des revendications 1 à 12, dans lequel l'étape c) est exécutée en appliquant un recuit thermique à l'assemblage obtenu à l'issue de l'étape b).

14. Procédé selon l'une des revendications 1 à 13, dans lequel le substrat donneur (3) prévu lors de l'étape a) est réalisé dans un matériau sélectionné parmi :
- un matériau semi-conducteur, de préférence Si, Ge, GaAs, InP, GaN ;
- un matériau piézoélectrique, de préférence LiNbO₃, LiTaO₃.

## Patentansprüche

1. Verfahren zur Übertragung einer Nutzschicht (1) auf ein Trägersubstrat (2) mit einer ersten Fläche (20), wobei das Verfahren die folgenden aufeinanderfolgenden Schritte aufweist:
a) Vorsehen eines Donorsubstrats (3) aufweisend:
- eine erste Fläche (30),
- einen Schwächungsbereich (ZS) umfassend implantierte Arten,
- die Nutzschicht (1), die von dem Schwächungsbereich (ZS) und von der ersten Fläche (30) des Donorsubstrats (3) begrenzt ist,
- einen amorphen Bereich (4), der sich in der Nutzschicht (1) parallel zum Schwächungsbereich (ZS) erstreckt;
b) Zusammenfügen des Donorsubstrats (3) mit dem Trägersubstrat (2) durch ein Verkleben auf der Seite der ersten Fläche (30) des Donorsubstrats (3) und der Seite der ersten Fläche (20) des Trägersubstrats (2); wobei der Schritt b) so ausgeführt wird, dass sich der amorphe Bereich (4) zumindest teilweise gegenüber mindestens eines Hohlraums (200) befindet, der zum Teil von der ersten Fläche (30) des Donorsubstrats (3) begrenzt ist;
c) Aufbrechen des Donorsubstrats (3) nach dem Schwächungsbereich (ZS), um die Nutzschicht (1) freizulegen.

2. Verfahren nach Anspruch 1, wobei der Hohlraum (200) auf der ersten Fläche (20) des Trägersubstrats (2) angeordnet ist;
und wobei das Verkleben des Schritts b) zwischen der ersten Fläche (30) des Donorsubstrats (3) und der ersten Fläche (20) des Trägersubstrats (2) erfolgt.

3. Verfahren nach Anspruch 1, wobei das Trägersubstrat (2) Säulen (6) aufweist, die sich an der ersten Fläche (20) des Trägersubstrats (2) erstrecken und den Hohlraum (200) zum Teil begrenzen;
und wobei das Verkleben des Schritts b) zwischen der ersten Fläche (30) des Donorsubstrats (3) und den Säulen (6) des Trägersubstrats (2) erfolgt.

4. Verfahren nach Anspruch 1, wobei das Trägersubstrat (3), das bei Schritt a) vorgesehen wird, Säulen (6') aufweist, die sich an der ersten Fläche (30) des Trägersubstrats (3) erstrecken und den Hohlraum (200) zum Teil begrenzen;
und wobei das Verkleben des Schritts b) zwischen den Säulen (6') des Donorsubstrats (3) und der ersten Fläche (20) des Trägersubstrats (2) erfolgt.

5. Verfahren nach Anspruch 1, wobei das Trägersubstrat (2) Säulen (6) aufweist, die sich an der ersten Fläche (20) des Trägersubstrats (2) erstrecken und einen ersten Hohlraum (200a) zum Teil begrenzen;
wobei das Trägersubstrat (3), das bei Schritt a) vorgesehen wird, Säulen (6') aufweist, die sich an der ersten Fläche (30) des Trägersubstrats (3) erstrecken und einen zweiten Hohlraum (200b) zum Teil begrenzen;
und wobei das Verkleben des Schritts b) zwischen den Säulen (6') des Donorsubstrats (3) und den Säulen (6) des Trägersubstrats (2) so erfolgt, dass der erste und zweite Hohlraum (200a, 200b) vereint werden und den Hohlraum (200) bilden.

6. Verfahren nach einem der Ansprüche 1 bis 5, aufweisend einen Schritt d), der darin besteht, den amorphen Bereich (4) zu rekristallisieren, wobei der Schritt d) nach dem Schritt c) ausgeführt wird; wobei der Schritt d) vorzugsweise durch ein epitaktisches Wiederaufwachsen in der Festphase ausgeführt wird.

7. Verfahren nach einem der Ansprüche 1 bis 6, wobei der Schritt a) die folgenden Schritte aufweist:
a₀) Vorsehen des Donorsubstrats (3) mit der ersten Fläche (30);
a₁) Bilden des Schwächungsbereichs (ZS) in dem Donorsubstrat (3);
a₂) Bilden des amorphen Bereichs (4) in der Nutzschicht (1).

8. Verfahren nach Anspruch 7, wobei der Schritt a₁) darin besteht, ionisierte Arten in dem Donorsubstrat (3) durch die erste Fläche (30) des Donorsubstrats (3) zu implantieren, wobei die ionisierten Arten vorzugsweise mindestens eine der Arten aufweisen, die aus H⁺, He⁺, B⁺ ausgewählt sind.

9. Verfahren nach Anspruch 7 oder 8, wobei der Schritt a₂) darin besteht, Arten in der Nutzschicht (1) durch die erste Fläche (30) des Donorsubstrats (3) zu implantieren, wobei die Arten vorzugsweise Siliziumionen oder Germaniumionen sind.

10. Verfahren nach einem der Ansprüche 7 bis 9, wobei der Schritt a₂) so ausgeführt wird, dass sich der amorphe Bereich (4) in einer Entfernung von der ersten Fläche (30) des Donorsubstrats (3) erstreckt.

11. Verfahren nach einem der Ansprüche 7 bis 10, wobei die Nutzschicht (1) des Donorsubstrats (3), das beim Schritt a) vorgesehen wird, eine Volumendichte aufweist, die mit ρ₁ angegeben ist;
und wobei der Schritt a₂) so ausgeführt wird, dass der amorphe Bereich (4) eine Volumendichte aufweist, die mit ρ₂ angegeben ist, wobei ρ₂ ≥ ρ₁/10.

12. Verfahren nach einem der Ansprüche 7 bis 11, wobei die Nutzschicht (1) des Donorsubstrats (3), das beim Schritt a) vorgesehen wird, eine Dicke aufweist, die mit t angegeben ist, die eine theoretische maximale Breite des Hohlraums definiert, die mit Wₗᵢₘ angegeben ist, die proportional zu t² ist;
und wobei der Schritt a₂) so ausgeführt wird, dass der amorphe Bereich (4) ein periodisches Gitter mit einem Abstand bildet, der mit p angegeben ist, wobei p < Wₗᵢₘ, wobei sich das periodische Gitter parallel zur ersten Fläche (30) des Donorsubstrats (3) erstreckt.

13. Verfahren nach einem der Ansprüche 1 bis 12, wobei der Schritt c) unter Anwendung einer Wärmebehandlung auf den Aufbau, der am Ende des Schritts b) erhalten wird, ausgeführt wird.

14. Verfahren nach einem der Ansprüche 1 bis 13, wobei das Donorsubstrat (3), das beim Schritt a) vorgesehen wird, aus einem Material hergestellt ist, das aus Folgendem ausgewählt ist:
- einem Halbleitermaterial, vorzugsweise Si, Ge, GaAs, InP, GaN;
- einem piezoelektrischen Material, vorzugsweise LiNbO₃, LiTaO₃.

## Claims

1. Process for transferring a useful layer (1) to a carrier substrate (2) including a first surface (20), the process including the successive steps of:
a) providing a donor substrate (3) including:
- a first surface (30),
- a weakened zone (ZS) comprising implanted species,
- the useful layer (1), which is bounded by the weakened zone (ZS) and by the first surface (30) of the donor substrate (3),
- an amorphous zone (4) lying, in the useful layer (1), parallel to the weakened zone (ZS);
b) assembling, on the side of the first surface (30) of the donor substrate (3) and on the side of the first surface (20) of the carrier substrate (2), the donor substrate (3) with the carrier substrate (2) by bonding; step b) being executed so that the amorphous zone (4) is at least partially facing at least one cavity (200) that is partially bounded by the first surface (30) of the donor substrate (3);
c) splitting the donor substrate (3) along the weakened zone (ZS) so as to reveal the useful layer (1).

2. Process according to Claim 1, wherein the cavity (200) is produced in the first surface (20) of the carrier substrate (2);
and wherein the bonding of step b) is carried out between the first surface (30) of the donor substrate (3) and the first surface (20) of the carrier substrate (2).

3. Process according to Claim 1, wherein the carrier substrate (2) includes pillars (6) extending to the first surface (20) of the carrier substrate (2) and partially bounding the cavity (200);
and wherein the bonding of step b) is carried out between the first surface (30) of the donor substrate (3) and the pillars (6) of the carrier substrate (2).

4. Process according to Claim 1, wherein the donor substrate (3) provided in step a) includes pillars (6') extending to the first surface (30) of the donor substrate (3) and partially bounding the cavity (200);
and wherein the bonding in step b) is carried out between the pillars (6') of the donor substrate (3) and the first surface (20) of the carrier substrate (2).

5. Process according to Claim 1, wherein the carrier substrate (2) includes pillars (6) extending to the first surface (20) of the carrier substrate (2) and partially bounding a first cavity (200a);
wherein the donor substrate (3) provided in step a) includes pillars (6') extending to the first surface (30) of the donor substrate (3) and partially bounding a second cavity (200b);
and wherein the bonding of step b) is carried out between the pillars (6') of the donor substrate (3) and the pillars (6) of the carrier substrate (2) so as to join the first and second cavities (200a, 200b) and form the cavity (200).

6. Process according to one of Claims 1 to 5, including a step d) consisting in recrystallizing the amorphous zone (4), step d) being executed after step c); step d) preferably being executed by solid-phase epitaxial regrowth.

7. Process according to one of Claims 1 to 6, wherein step a) includes the steps of:
a₀) providing the donor substrate (3) including the first surface (30);
a₁) forming the weakened zone (ZS) in the donor substrate (3);
a₂) forming the amorphous zone (4) in the useful layer (1).

8. Process according to Claim 7, wherein step a₁) consists in implanting ionized species in the donor substrate (3), through the first surface (30) of the donor substrate (3), said ionized species preferably including at least one species selected from H⁺, He⁺ and B⁺.

9. Process according to Claim 7 or 8, wherein step a₂) consists in implanting species in the useful layer (1), through the first surface (30) of the donor substrate (3), said species preferably being silicon ions or germanium ions.

10. Process according to one of Claims 7 to 9, wherein step a₂) is executed so that the amorphous zone (4) lies at distance from the first surface (30) of the donor substrate (3).

11. Process according to one of Claims 7 to 10, wherein the useful layer (1) of the donor substrate (3) provided in step a) has a volume density, denoted ρ₁;
and wherein step a₂) is executed so that the amorphous zone (4) has a volume density, denoted ρ₂, satisfying ρ₂ ≥ ρ₁/10.

12. Process according to one of Claims 7 to 11, wherein the useful layer (1) of the donor substrate (3) provided in step a) has a thickness, denoted t, defining a maximum theoretical width of the cavity, denoted Wₗᵢₘ, that is proportional to t²;
and wherein step a₂) is executed so that the amorphous zone (4) forms a periodic array with a pitch, denoted p, satisfying p < Wₗᵢₘ, the periodic array lying parallel to the first surface (30) of the donor substrate (3).

13. Process according to one of Claims 1 to 12, wherein step c) is executed by applying a thermal anneal to the assembly obtained at the end of step b).

14. Process according to one of Claims 1 to 13, wherein the donor substrate (3) provided in step a) is made from a material selected from:
- a semiconductor, preferably Si, Ge, GaAs, InP or GaN;
- a piezoelectric material, preferably LiNbO₃ or LiTaO₃.
